# EUROPÄISCHE PATENTANMELDUNG

(11) **EP 1 217 877 A2**
(43) Veröffentlichungstag der Anmeldung: **26.06.2002**
(21) Anmeldenummer: 01250448.6
(22) Anmeldetag: 21.12.2001
(51) Int. Cl.: H05K 1/00

(54) **Verfahren zur Herstellung von schaltungstragenden Kunststoffgehäusen elektronischer Bauteile**

(30) Priorität: 22.12.2000 DE 10065856
(71) Anmelder: SIEMENS AKTIENGESELLSCHAFT, 80333 München (DE)
(72) Erfinder: Fricke, Christian, Dr., 14050 Berlin (DE); Hartmann, Ulrich, 90562 Kalchreuth (DE)

(57) **Zusammenfassung**

Elektronik-Bauteile, bei denen Leiterbahnen direkt in die innenseitige Oberfläche von Kunststoffgehäusen integriert sind, müssen mit Kontaktstiften versehen werden, die nach einiger Zeit nicht mehr kontaktsicher sind.

Nach dem vorliegenden Verfahren werden keine Kontaktstifte benötigt, indem in einem Zweikomponentenspritzgießverfahren in einem ersten Spritzgießvorgang unter Verwendung eines elektrisch leitfähigen Kunststoffs elektrische Leiterbahnen der Schaltung einschließlich der später durch Wandungen hindurchgehenden Verbindungen spritzgegossen werden und in einem zweiten Spritzgießvorgang ein Umgießen der Leiterbahnen mit einem nichtleitenden Kunststoff zu der fertigen Gehäuseform erfolgt.

## Beschreibung

Die Erfindung betrifft ein Verfahren zur Herstellung von schaltungstragenden Kunststoffgehäusen elektronischer Bauteile.

Der Trend zur Miniaturisierung von Elektronik-Bauteilen hat zur Realisierung von Systemen geführt, bei denen Leiterbahnen direkt in die innenseitige Oberfläche von Kunststoffgehäusen integriert und von dort mit Mikroprozessoren, Sensoren, Schaltern etc. verbunden sind. Auf eine separate Leiterplatte kann dann verzichtet werden.

Bekannt ist hierzu ein Herstellungsverfahren mittels Zweikomponentenspritzgießen. Das Verfahren beruht auf der Verwendung von zwei Kunststoffen mit unterschiedlichem Metallisierungsverhalten. In einem ersten Verfahrensschritt wird ein Gehäuseteil mit erhabenen Strukturen aus einem metallisierbaren Kunststoff spritzgegossen. Die Oberflächen dieser erhabenen Strukturen bilden später die vorgesehenen Leiterbahnen. In einem zweiten Schritt erfolgt das Umgießen dieser Strukturen mit einem nicht metallisierbaren Kunststoff, wobei die Oberfläche der Leiterbahnstrukturen frei bleibt. In einem dritten Verfahrensschritt werden die Leiterbahnen, üblicherweise durch Galvanisierung, metallisiert. Für Wanddurchgänge, insbesondere für einen äußeren Anschluss eines solchen Elektronik-Bauteils sind Kontaktstifte vorgesehen, die mit den Leiterbahnen im Inneren des Bauteils verbunden werden müssen. Für den Spritzvorgang werden deshalb Löcher in der Wandung vorgesehen, in die anschließend an das Spritzgießen derartige Kontaktstifte eingepresst werden. Die Kontaktstifte können kompakt sein oder aus metallisiertem Kunststoff bestehen.

Alternativ zu den beschriebenen Verfahrensschritten kann in einem ersten Verfahrensschritt auch die Leiterbahnstruktur als Vertiefung aus der nichtmetallisierbaren Komponente hergestellt und in einem zweiten Verfahrensschritt mit der metallisierbaren Komponente ausgefüllt werden.

Das Verfahren ist z. B. aus Kuhmann et al, Raumstrukturen, 3-D MID - Mehrkomponentenspritzgießen strukturierter Schaltungsträger, Plastverarbeiter 48 (1997) 10, S. 30-34 bekannt.

Die Funktionsfähigkeit metalliserter Kontaktstifte ist gegeben, solange eine äußere Steckverbindung nur ein- oder wenige Male aufgesteckt werden muss. Bei einer größeren Anzahl von Steckvorgängen lockern sich die Stifte jedoch schnell.

In jedem Fall sind die Kontaktstifte unter Medien- und Witterungseinfluss korrosionsanfällig und so nach einiger Zeit nicht mehr kontaktsicher bzw. lassen sie dann Kriechwege für Feuchtigkeit etc. zu, so dass auch die Funktion von Bauelementen im Inneren des Elektronik-Bauteils beeinträchtigt werden kann.

Weiterhin ist gemäß dem deutschen Gebrauchsmuster DE 295 21 258 U1 ein Gehäuse offenbart, bei dem Leiterbahnen auf der Innenseite der Gehäusewand vorgesehen sind. Weiterhin ragen von dieser Gehäuseinnenwand Steckkontaktelemente in das Innere des Gehäuses, welche als an die Gehäusewand angeformte Kunststoffdome ausgeführt sind und an denen die Leiterbahnen von der Gehäusewand zur Bildung eines elektrischen Kontaktes mit einem zugehörigen Steckelement bis zu den freien Enden der Kontaktelemente geführt sind. Mit den freien Enden ragen die Steckkontaktelemente vom Inneren des Gehäuses durch eine Öffnung aus dem Gehäuse heraus, ohne die Gehäusewandungen jedoch zu berühren, so dass das Steckelement zur Kontaktierung durch diese Gehäuseöffnung auf die Steckkontaktelemente gesteckt werden kann.

Die Erfindung geht von einem solchen Verfahren aus, also einem Verfahren zur Herstellung von schaltungstragenden Kunststoffgehäusen mit elektronischen Bauteilen und an diese herangeführten Leiterbahnen, bei dem in einem Zweikomponenten-Spritzgießverfahren in einem ersten Spritzgießvorgang unter Verwendung eines elektrisch leitfähigen Kunststoffs die Leiterbahnen einschließlich der später durch Wandungen hindurchgehenden Verbindungen und die sich an diese anschließenden Leiterbahnkontakte spritzgegossen werden, und stellt sich die Aufgabe, die Steckkontaktelemente bzw. ihre Verbindungen mediendicht im Kunststoffgehäuse herzustellen.

Erfindungsgemäß wird die Aufgabe gelöst durch die Merkmale des Anspruchs 1. Zweckmäßige Ausgestaltungen sind Gegenstand der Unteransprüche.

Danach werden in einem Zweikomponentenspritzgießverfahren in einem ersten Spritzgießvorgang unter Verwendung eines elektrisch leitfähigen Kunststoffs elektrische Leiterbahnen der Schaltung einschließlich der später durch Wandungen hindurchgehenden Verbindungen spritzgegossen und in einem zweiten Spritzgießvorgang erfolgt ein Umgießen der Leiterbahnen und ein vollständiges Umgießen der Verbindungen mit einem nichtleitenden Kunststoff zu der fertigen Gehäuseform.

Durch das Verfahren fallen die bisher benötigten Kontaktstifte völlig weg. Die Herstellung vereinfacht sich durch den Wegfall der Arbeitsschritte Galvanisieren und Einbringen der Kontaktstifte.

Die Leiterbahndurchführungen durch innere oder äußere Wandungen sind nunmehr dauerhaft mediendicht. Es existieren keine Übergangswiderstände im Bereich der Wanddurchführungen. Zwischen äußerem Steckkontakt und den inneren Leiterbahnen besteht eine gleichmäßige elektrische Leitfähigkeit.

Es ist zwar aus der deutschen Patentanmeldung DE 198 08 178 bekannt, dass gespritzte Verdrahtungspfade aus leitfähigem Kunststoff durch einen ein Gehäuse bildenden Rahmen hindurch geführt werden, um eine elektrische Steckverbindung zu erzeugen, jedoch sind diese Verdrahtungspfade an als gesonderte Bauteile ausgeführte Steckkontakte angespritzt.

Als elektrisch leitfähige Kunststoffe lassen sich mit Metallpulvern gefüllte Kunststoffcompounds einsetzen, wobei hohe Füllgrade anzustreben sind. Eine eventuelle Abnahme der mechanischen Festigkeit des Kunststoffcompounds bei hohen Füllgraden wird durch das Umspritzen mit einer nichtleitfähigen Kunststoffkomponente kompensiert.

Für Anwendungen mit geringen Stromflüssen kann die Füllstoffauswahl oder die Füllstoffkonzentration variiert werden. Auch die Verwendung von Füllstoffen mit geringerer Eigenleitfähigkeit wie Graphit oder Kohlenstofffasern ist in einem solchen Fall möglich.

Kunststoffe mit eincompoundierten, niedrigschmelzenden Metall-Legierungen können mit Metallen vergleichbare elektrische Leitfähigkeiten erreichen, wenn die Metallpartikel nach der Formgebung zu einer durchgehenden metallischen Phase umgeschmolzen werden. Das Umschmelzen kann z. B. durch konvektive Wärmebehandlung erfolgen. Die Metall-Legierungen sind so an den betreffenden Kunststoff anzupassen, dass ihre Schmelztemperatur oberhalb der Verarbeitungstemperatur der verwendeten Kunststoffe, aber noch unterhalb von deren Zersetzungstemperatur liegt.

Die Erfindung soll nachstehend anhand eines Ausführungsbeispiels näher erläutert werden. die zugehörige Zeichnung zeigt ein Elektronik-Bauteil 1, das nach dem erfindungsgemäßen Verfahren hergestellt ist.

Derartige Bauteile sind unter dem Begriff 3D-MID bekannt. 3D-MID sind multifunktionale, produktspezifische Bauteile mit integrierten elektrischen und gegebenenfalls weiteren mechanischen, optischen und thermischen Funktionen.

Das Elektronik-Bauteil 1 besteht aus einem Kunststoffgehäuse 2, in dessen innere Oberfläche Leiterbahnen 3 direkt integriert sind. Die Leiterbahnen 3 sind mit einem Chip 4 zu Verarbeitung von Daten verbunden, die über die Leiterbahnen 3 z. B. von Sensoren eines Kraftfahrzeuges empfangen werden.

Das Elektronik-Bauteil 1 wird nach dem vorliegenden Verfahren mittels Zweikomponentenspritzgießen auf folgende Weise hergestellt:
In einem ersten Verfahrensschritt werden die Leiterbahnen 3 durchgehend aus einem elektrisch leitfähigen Compound gespritzt. Der Compound besteht aus einem Kunststoff, der mit hohem Füllgrad mit einem Metallpulver versetzt ist. In einem zweiten Verfahrensschritt werden die Leiterbahnen 3 mit einem nichtleitfähigen Kunststoff zu dem fertigen Gehäuse 2 umspritzt. Bei diesem zweiten Verfahrensschritt bilden sich so auch die Durchführungen als durch eine Gehäusewand 5 hindurchgehende Verbindung. Die am Gehäuse 2 dann außen liegenden Teile der Leiterbahnen 3 bilden Leiterbahnkontakte, welche direkt mit einem nicht dargestellten Stecker kontaktiert werden können. Alternativ (nicht dargestellt) können sich an die durch die Durchführungen gebildeten Verbindungen durch die Gehäusewand 5 auch mit diesen in einem Stück gegossene Steckkontaktelemente anschließen, die beispielsweise stiftartig nach außen von der Gehäusewand 5 abstehen, so dass diese Steckkontaktelemente mit einem elektrischen Steckverbinder in Verbindung gebracht werden können.

Die durch die Gehäusewand 5 durchgehenden Leiterbahnen 3 werden dicht von dem nichtleitfähigen Kunststoff umschlossen, so dass das Gehäuse 2 mit einem weiteren, hier nicht gezeigten Gehäuseteil mediendicht verschlossen werden kann.

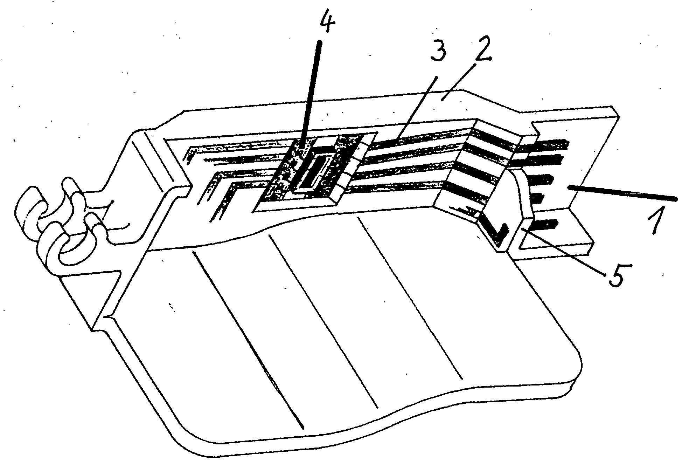

## Patentansprüche

1. Verfahren zur Herstellung von schaltungstragenden Kunststoffgehäusen mit elektronischen Bauteilen und an diese herangeführten Leiterbahnen, bei dem in einem Zweikomponenten-Spritzgießverfahren in einem ersten Spritzgießvorgang unter Verwendung eines elektrisch leitfähigen Kunststoffs die Leiterbahnen einschließlich der später durch Wandungen hindurchgehenden Verbindungen und die sich an diese anschließenden Steckkontaktelemente spritzgegossen werden,
**dadurch gekennzeichnet, dass** in einem zweiten Spritzgießvorgang ein Umgießen der Leiterbahnen und ein vollständiges Umgießen der Verbindungen mit einem nichtleitenden Kunststoff zu der fertigen Gehäuseform erfolgt.

2. Verfahren nach Anspruch 1,
**dadurch gekennzeichnet, dass** als elektrisch leitfähiger Kunststoff ein mit einer niedrigschmelzenden Metall-Legierung compoundierter Kunststoff verwendet wird und nach dem Spritzgießen eine Wärmebehandlung zum Aufschmelzen der Metall-Legierung erfolgt.

3. Verfahren nach Anspruch 2,
**dadurch gekennzeichnet, dass** für den leitfähigen Kunststoff eine Metall-Legierung verwendet wird, deren Schmelztemperatur oberhalb der Verarbeitungstemperatur sowohl des für die leitfähige als auch für die nichtleitfähige Komponente eingesetzten Kunststoffs, aber unterhalb deren Zersetzungstemperatur liegt.
